Europäisches Patentamt

European Patent Office

Office européen des brevets

(19)

(11) Veröffentlichungsnummer: **0 301 119**
**B1**

(12) EUROPÄISCHE PATENTSCHRIFT

(45) Veröffentlichungstag der Patentschrift:
**31.01.90**

(21) Anmeldenummer: **87110979.9**

(22) Anmeldetag: **29.07.87**

(51) Int. Cl.⁴: **H05K 7/14**

(54) Steckbaugruppe.

(43) Veröffentlichungstag der Anmeldung:
**01.02.89 Patentblatt 89/5**

(45) Bekanntmachung des Hinweises auf die Patenterteilung:
**31.01.90 Patentblatt 90/5**

(84) Benannte Vertragsstaaten:
**BE CH DE FR GB IT LI LU NL**

(56) Entgegenhaltungen:
**EP-A- 0 191 968**
**DE-A- 3 146 904**
**GB-A- 2 115 062**
**GB-A- 2 188 196**
**US-A- 4 530 615**

(73) Patentinhaber: **Schroff GmbH, Industriegeblet,
D-7541 Straubenhardt 1(DE)**

(72) Erfinder: **Schwenk, Hans-Martin, Wiesenweg 9,
D-7541 Straubenhardt 2(DE)**
Erfinder: **Mazura, Paul, Turmbergstrasse 22,
D-7516 Karlsbad-Spielberg(DE)**
Erfinder: **Waltz, Elke Royal Crest Estates App.Nr. 10, 20,
Cedar Pont Brive, Warwick R.I. 02 886(US)**

(74) Vertreter: **Durm, Klaus, Dr.-Ing. et al, Patentanwälte
Dr.-Ing. Klaus Durm Dipl.-Ing. Frank Durm
Felix-Mottl-Strasse 1a, D-7500 Karlsruhe 21(DE)**

## Beschreibung

Die Erfindung bezieht sich auf eine Steckbaugruppe zum Einschieben in Baugruppenträger elektronischer Geräte, mit einer elektronische und elektrische Bauelemente tragenden und mit einer Steckvorrichtung ausgestatteten Leiterplatte, an der mittels eines Haltebockes eine Frontplatte rechtwinklig befestigt ist, sowie mit einem an der Frontplatte mit seinem Griffteil hervorragenden Ausheber, der mittels an zwei hervorstehenden parallelen Seitenwänden angeordneter Lagerlöcher an zwei im Bereich der Frontplatte vorgesehenen, koaxialen Schwenkzapfen schwenkbar angeordnet ist.

Die Erfindung findet Anwendung bei in Baugruppenträger einschiebbare Steckbaugruppen verschiedener Größe, wie diese zum Aufbau von elektronischen und elektrischen Geräten vielfach benutzt werden.

Steckbaugruppen sind mit Hilfe von vielpoligen Steckverbindern mit den Baugruppenträgern verbunden. Dreireihige Steckverbinder mit 96 Kontakten benötigen sowohl zum Einstecken wie zum Ausziehen hohe Kräfte; ohne geeignete Hilfsmittel lassen sich Steckbaugruppen kaum aus den Baugruppenträgern entfernen.

Als Hilfsmittel zum Ausziehen von Steckbaugruppen dienen Hebelsysteme mit Aushebegriffen, die in verschiedenen Ausführungsformen bekannt sind. So zeigt die DE-OS 33 22 856 ein Frontsystem für Steckbaugruppen mit aufwendigen Winkelhebeln, die mit einer Rastvorrichtung versehen sind, während die US-PS 4 603 375 einen Auswerfer für Steckbaugruppen beschreibt, dessen Griffteil durch eine Öffnung der Frontplatte hinausragt und der an einem Haltebock auf der Befestigungsschraube für die Leiterplatte gelagert ist, was ungünstige Hebelkräfte bedingt. Das DE-GM 8 607 046 offenbart einen kompliziert gestalteten Haltebock für die Leiterplatte, in welchen die Frontplatte mit ihrem Ende eingeschoben ist und der an die horizontale Profilschiene des Baugruppenträgers angeschraubt wird.

Es ist Aufgabe der Erfindung, Frontplatte, Haltebock und Ausheber so auszubilden, daß diese Teile einfach hergestellt werden können, daß ihre Montage schnell vonstatten geht und daß hohe Ausziehkräfte am Steckverbinder erzielt werden können.

Zur Lösung der gestellten Aufgabe wird von einer Steckbaugruppe der eingangs erwähnten Bauart ausgegangen und gelöst wird die Aufgabe dadurch, daß die Frontplatte an ihren Länskanten zwei einander gegenüberliegende Ausnehmungen aufweist, in welche die Seitenwände des Aushebers eingreifen, und die beiden Schwenkzapfen in diesen Ausnehmungen stehen und in der Ebene der Frontplatte liegen. Diese Lage der beiden Schwenkzapfen ergibt optimale Hebelverhältnisse für den Ausheber.

In einer Ausführungsform der Erfindung sind die Schwenkzapfen am Haltebock angeordnet, und zwar sind sie an am Haltebock hervorstehenden Tragböcken angeordnet, die in korrespondierende Aussparungen der Frontplatte eingreifen.

Um ein Verdrehen der Leiterplatte zu verhindern, trägt der Haltebock eine Anlegekante.

In einer anderen Ausführungsform der Erfindung sind die Schwenkzapfen an der Frontplatte angeordnet, und zwar an dieser angeformt.

Zur Erleichterung des Einsetzens ds Aushebers sind dessen Seitenwände als Federzungen ausgebildet, welche die Lagerlöcher tragen. Diese Federzungen sind am Ausheber angeformt. Der gleiche Ausheber findet bei beiden Ausführungsformen der Erfindung Verwendung.

In einer anderen Ausführungsform des Aushebers besitzt dieser eine seitliche Vertiefung, in welche eine der beiden Seitenwände formschlüssig eingesetzt ist. Diese eingesetzte Seitenwand weist einen Dorn auf, der in eine Sackbohrung des Aushebers eingreift. Am Dorn kann eine Nase angeordnet sein, die in eine Mulde der Sackbohrung paßt. Diese Maßnahmen dienen der Befestigung der formschlüssig eingesetzten Seitenwand.

Wenigstens einer der beiden Schwenkzapfen kann an seinem Mantel eine Rastfläche aufweisen, und das zugehörige Lagerloch kann eine entsprechende Gegenfläche sowie zwei seitlich sich anschließende, radiale Schlitze tragen. Mit Hilfe dieser Rasteinrichtung kann der Ausheber in einer vorgesehenen Stellung gehalten werden. Das gleiche Ergebnis kann dadurch erzielt werden, daß am Haltebock seitlich eine Kuppe vorgesehen ist, welcher eine Senke an der Seitenwand gegenübersteht.

An den Lagerlöchern des Aushebers können Einlaufschrägen vorgesehen sein, welche das Aufstecken des Aushebers auf die beiden Schwenkzapfen erleichtert.

Die Erfindung wird nachstehend an zwei Ausführungsbeispielen und unter Bezugnahme auf die beigefügten Zeichnungen näher erläutert. In den Zeichnungen zeigen

Fig. 1 eine Steckbaugruppe in perspektivischer Darstellung, die Einzelteile explosionsartig auseinandergezogen, in einem etwa um das Doppelte vergrößerten Maßstab, wobei die Frontplatte und die Leiterplatte nur teilweise wiedergegeben sind;

Fig. 2 den Ausheber der Steckbaugruppe nach Fig. 1, in einer Rückansicht;

Fig. 3 eine zweite Ausführungsform des Aushebers der Steckbaugruppe nach Fig. 1 mit einer einsetzbaren Seitenwand;

Fig. 4 eine zweite Steckbaugruppe, bei welcher die Schwenkzapfen an der Frontplatte angeformt sind, ebenfalls in perspektivischer, explosionsartiger Darstellung;

Fig. 5 einen Teil eines Aushebers mit einem Lagerloch, von der Seite gesehen, in gegenüber Figur 4 vergrößerter Darstellung;

Fig. 6 eine Teilansicht der Frontplatte der Steckbaugruppe nach Figur 4, ebenfalls von der Seite gesehen und in vergrößerter Wiedergabe.

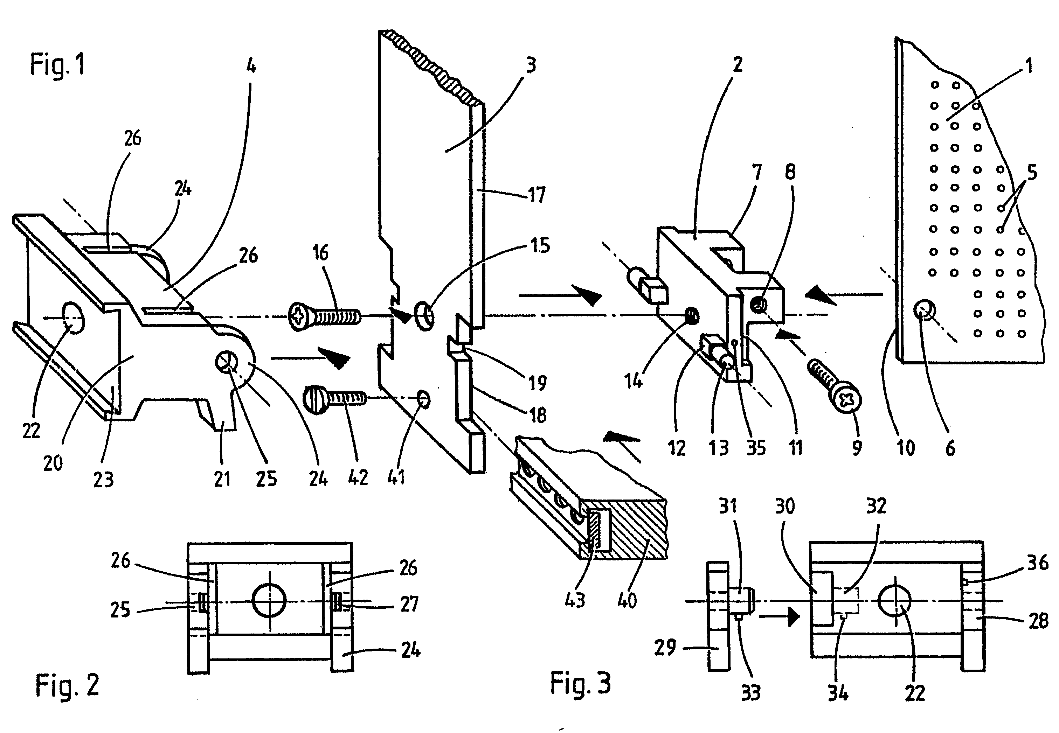

Die in der Figur 1 dargestellte Steckbaugruppe ist im wesentlichen aus vier Teilen, nämlich einer Leiterplatte 1, einem Haltebock 2, einer Frontplatte 3 sowie einem Ausheber 4 zusammengesetzt.

Die abgebrochen dargestellte Leiterplatte 1 besteht aus Isoliermaterial und weist ein Raster von Löchern zur Befestigung von elektronischen und elektrischen Bauelementen (nicht dargestellt) auf. Im Bereich ihrer Ecke trägt die Leiterplatte 1 ein Befestigungsloch 6, welches zum Anschrauben der Leiterplatte 1 an dem Haltebock 2 dient.

Der aus einem geeigneten Material, zum Beispiel Metall oder Kunststoffguß, hergestellte Haltebock 2 trägt an seiner Rückseite zwei parallele Haltenasen 7 mit Gewindebohrungen 8 für eine Zylinderkopfschraube 9, die zum Anschrauben der Leiterplatte 1 dient, deren Vorderkante 10 sich an eine Anlegekante 11 des Haltebocks 2 anlegt.

An der der Frontplatte 3 zugewandten Vorderseite des Haltebockes 2 sind zwei würfelförmige Tragböcke 12 angeordnet, an welchen zwei jeweils nach außen stehende, koaxiale Schwenkzapfen 13 vorgesehen sind. Die beiden Tragböcke 12 sind zusammen mit den Schwenkzapfen 13 am Haltebock 2 angeformt.

Der Haltebock 2 trägt an seiner Vorderseite ein Gewindeloch 14. Mittels des Haltebockes 2 ist die Frontplatte 3 rechtwinklig an der Leiterplatte 1 befestigt.

Die aus Metall oder Kunststoff bestehende und ebenfalls abgebrochen wiedergegebene Frontplatte 3 von rechteckigem Grundriß trägt ein Befestigungsloch 15 mit angesenktem Rand; die Frontplatte ist mit einer Senkkopfschraube 16 am Haltebock 2 angeschraubt.

Die Frontplatte 3 weist an ihren beiden Längskanten 17 in gleicher Höhe und somit einander gegenüberliegend zwei im Grundriß rechteckige Ausnehmungen 18 auf. In diesen Ausnehmungen 18 sind quadratische Aussparungen 19 vorgesehen. Die Aussparungen 19 korrespondieren mit den Tragböcken 12 des Haltebockes 2 in der Weise, daß bei an den Haltebock 2 angeschraubter Frontplatte 3 die Tragböcke 12 in den Aussparungen 19 sitzen und die Schwenkzapfen 13 in den Ausnehmungen 18 der Frontplatte 3 stehen, wobei sie auch in der Ebene der Frontplatte 3 liegen.

Der Ausheber 4 ist aus Metall oder Kunststoff hergestellt und weist ein Griffteil 20 sowei zwei Hebelarme 21 auf. Das Griffteil 20 wird von einem Durchgangsloch 22 durchsetzt, durch welches die Senkkopfschraube 16 zugänglich ist. Eine im Profil schwalbenschwanzförmige Nut 23 dient zum seitlichen Einschieben einer Deckleiste (nicht dargestellt).

Der Ausheber 4 weist zwei nach rückwärts hervorstehende, parallele Seitenwände 24 auf, die als Federzungen ausgebildet sind un in welchen Lagerböcke 25 zur Aufnahme der Schwenkzapfen 13 vorgesehen sind; dadurch ist der Ausheber 4 gegenüber der Frontplatte 3 schwenkbar. Zur Bildung der Federzungen weist der Ausheber 4 zwei Längsschlitze 26 auf. Die beiden,die Seitenwände 24 bildenden Federzungen greifen in die Ausnehmungen 18 der Frontplatte 3 ein.

An den Lagerlöchern 25 sind an den Innenflächen der als Federzungen ausgebildeten Seitenwände 24 radial gerichtete Einlaufschrägen 27 für die Schwenkzapfen 13 vorgesehen - vgl. Fig. 2.

Der Ausheber 4 kann, wie Figur 3 verdeutlicht, auch eine feste, angeformte Seitenwand 28 und eine einsetzbare Seitenwand 29 aufweisen, welche letztere formschlüssig in eine entsprechende, seitliche Vertiefung 30 paßt. Dabei trägt die einsetzbare Seitenwand 29 einen zylindrischen Dorn 31, der in eine Sackbohrung 32 des Aushebers 4 eingreift. Am Dorn 31 ist eine Nase 33 angeordnet, die in eine Mulde 34 einrastet.

Am Haltebock 2 ist seitlich eine Kuppe 35 vorgesehen, die mit einer Senke 36 an der Innenseite der festen Seitenwand 28 zusammenwirkt.

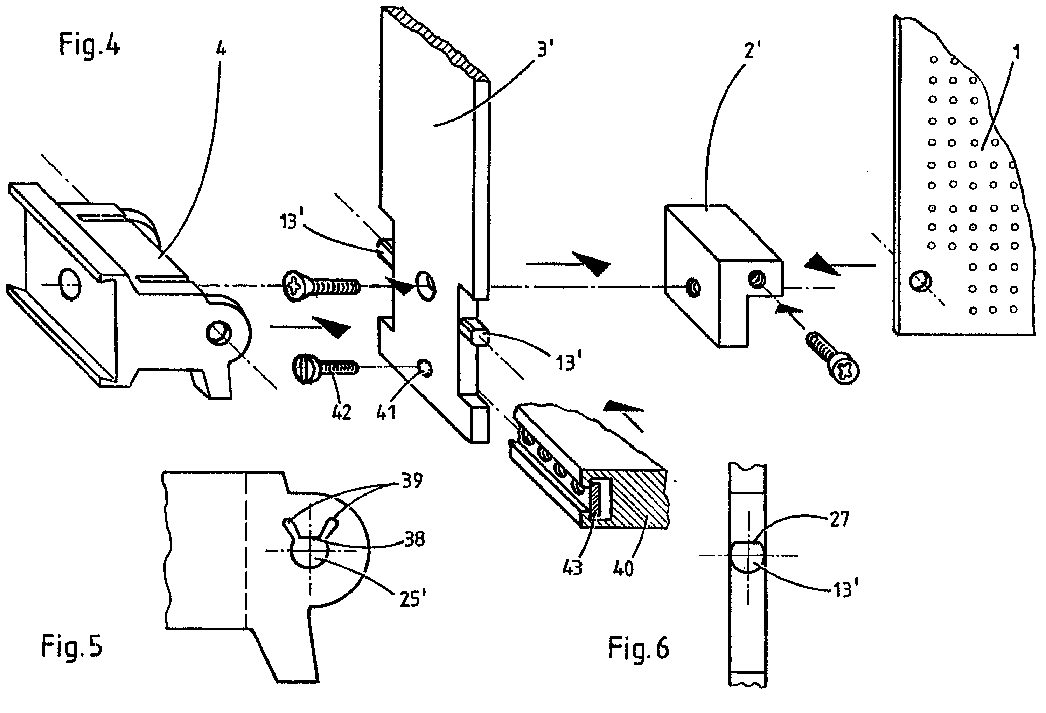

Die in Figur 4 dargestellte Steckbaugruppe stimmt im wesentliche mit derjenigen gemäß Figur 1 überein, jedoch weisen sowohl der Haltebock 2' wie die Frontplatte 3' eine abweichendeAusgestaltung auf.

Der Haltebock 2', welcher die Leiterplatte 1 mit der Frontplatte 3' verbindet, besitzt ein Winkelprofil und besteht aus Metall oder Kunststoff.

Die Schwenkzapfen 13', an welchen der Ausheber 4 - der mit demjenigen nach Figur 1 übereinstimmt - schwenkbar angeordnet ist, sind an der Frontplatte 3' angeordnet und dort angeformt.

Wenigstens einer der beiden Haltezapfen 13' kann - wie in Figur 6 dargestellt - eine Rastfläche 37 an seinem Mantel aufweisen und das zugehörige Lagerloch 25' (vgl. Figur 5) kann eine entsprechende Gegenfläche 38 sowie zwei seitlich sich anschließende, radial gerichtete Schlitze 39 tragen.

Zum Herausziehen der Steckbaugruppe aus dem Baugruppenträger wird das Griffteil 20 des Aushebers 4 niedergedrückt. Dadurch legt sich der Hebelarm 21 des Aushebers 4 gegen die horizontale Tragschiene 40 des Baugruppenträgers und die Steckbaugruppe bewegt sich während des Niederdrückens gegen die Kontakthaltekräfte der an der Leiterplatte 1 angeordneten Steckvorrichtung nach vorn aus dem Baugruppenträger heraus.

Die Frontplatte 3, 3' ist nahe ihren beiderseitigen Enden an der horizontalen Tragschiene 40 des - sonst nicht dargestellten - Baugruppenträgers unter Verwendung einer ein Befestigungsloch 41 durchsetzenden Zylinderkopfschraube 42 lösbar befestigt. Die Zylinderkopfschraube 42 greift in eine in die Tragschiene 40 eingeschobene Gewindeleiste 43 ein.

## Patentansprüche

1. Steckbaugruppe zum Einschieben in Baugruppenträger elektronischer Geräte, mit einer elektronische und elektrische Bauelemente tragenden und mit einer Steckvorrichtung ausgestatteten Leiterplatte, an der mittels eines Haltebockes eine Frontplatte rechtwinkelig befestigt ist, sowie mit einem an der Frontplatte mit seinem Griffteil Hervorragenden Ausheber, der mittels an zwei hervorstehenden, parallelen Seitenwänden angeordneter Lagerlöcher an zwei im Bereich der Frontplatte vorgesehenen, koaxialen Schwenkzapfen schwenkbar angeordnet ist, **dadurch gekennzeichnet,** daß die Frontplatte (3,3') an ihren Längskanten (17) zwei einander gegenüberliegende Ausnehmungen (18) aufweist, in welche die Seitenwände (24, 28, 29) des Aushebers (4) eingreifen, und die beiden Schwenkzapfen (13, 13') in diesen Ausnehmungen (18) stehen und in der Ebene der Frontplatte (3, 3') liegen.

2. Steckbaugruppe nach Anspruch 1, **dadurch gekennzeichnet,** daß die Schwenkzapfen (13, 13') am Haltebock (2) angeordnet sind.

3. Steckbaugruppe nach Anspruch 2, **dadurch gekennzeichnet,** daß die Schwenkzapfen (13, 13') an am Haltebock (2) hervorstehenden Tragböcken (12) angeordnet sind, die in korrespondierende Aussparungen (19) der Frontplatte (3) eingreifen.

4. Steckbaugruppe nach einem der Ansprüche 1 bis 3, **dadurch gekennzeichnet,** daß der Haltebock (2) eine Anlegekante (11) für die Leiterplatte (1) trägt.

5. Steckbaugruppe nach Anspruch 1, **dadurch gekennzeichnet,** daß die Schwenkzapfen (13') an der Frontplatte (3') angeordnet sind.

6. Steckbaugruppe nach Anspruch 5, **dadurch gekennzeichnet,** daß die Schwenkzapfen (13') an der Frontplatte (3') angeformt sind.

7. Steckbaugruppe nach den Ansprüchen 1 bis 6, **dadurch gekennzeichnet,** daß die Seitenwände (24) des Aushebers (4) als Federzungen ausgebildet sind, welche die Lagerlöcher (25, 25') tragen.

8. Steckbaugruppe nach Anspruch 7, **dadurch gekennzeichnet,** daß die Federzungen am Ausheber (4) angeformt sind.

9. Steckbaugruppe nach den Ansprüchen 1 bis 6, **dadurch gekennzeichnet,** daß der Ausheber (4) eine seitliche Vertiefung (30) besitzt, in welche die eine der beiden Seitenwände (29) formschlüssig eingesetzt ist.

10. Steckbaugruppe nach Anspruch 9, **dadurch gekennzeichnet,** daß die eingesetzte SSeitenwand (29) einen Dorn (31) aufweist, der in eine Sackbohrung (32) des Aushebers (4) eingreift.

11. Steckbaugruppe nach Anspruch 10, **dadurch gekennzeichnet** daß am Dorn (31) eine Nase (33) angeordnet ist, die in eine Mulde (34) der Sackbohrung (32) paßt.

12. Steckbaugruppe nach den Ansprüchen 1 bis 11, **dadurch gekennzeichnet,** daß wenigstens einer der Schwenkzapfen (13, 13') an seinem Mantel eine Rastfläche (37) aufweist, und das zugehörige Lagerloch (25, 25') eine entsprechende Gegenfläche (38) sowie zwei seitlich sich anschließende, radiale Schlitze (39) trägt.

13. Steckbaugruppe nach den Ansprüchen 1 bis 12, **dadurch gekennzeichnet,** daß an den Lagerlöchern (25, 25') Einlaufschrägen (27) vorgesehen sind.

14. Steckbaugruppe nach den Ansprüchen 1 bis 13, **dadurch gekennzeichnet,** daß am Haltebock (2) seitlich eine Kuppe (35) vorgesehen ist, welcher eine Senke (36) an der Seitenwand (24, 28) gegenübersteht.

**Claims**

1. Plug-in for insertion into module racks of electronic devices, with a printed circuit board which carries electronic and electrical components and which is equipped with a plug-in device, a front panel secured at a right angle to the printed circuit board by means of a support bracket, as well as an ejector having a gripper part projecting forwardly from the front panel and being pivotally arranged by means of two coaxial pivot pins located in the region of the front panel at two journal holes arranged in two projecting side walls, characterised in that at its longitudinal edges (17) the front panel (3, 3') has two mutually oppositely lying recesses (18) in which the side walls (24, 28, 29) of the ejector (4) engage, and both pivot pins (13, 13') are disposed in these recesses (18) and lie in the plane of the front panel (3, 3').

2. Plug-in unit according to claim 1, characterised in that the pivot pins (13, 13') are arranged on the support bracket.

3. Plug-in unit according to claim 2, characterised in that the pivot pins (13, 13') are arranged on carrier brackets (12) projecting from the support bracket (2) and engage in corresponding recesses (19) of the front panel (3).

4. Plug-in unit according to claims 1 to 3, characterised in that the support bracket (2) carries a register edge (11) for the printed circuit board (1).

5. Plug-in unit according to claim 1, characterised in that the pivot pins (13') are arranged at the front panel (3').

6. Plug-in unit according to claim 5, characterised in that the pivot pins (13') are moulded on the front panel (3').

7. Plug-in unit according to claims 1 to 6, characterised in that the side walls (24) of the ejector (4) are formed as spring tongues carrying the bearing holes (25, 25').

8. Plug-in unit according to claim 7, characterised in that the spring tongues are moulded on the ejector (4).

9. Plug-in unit according to claims 1 to 6, characterised in that the ejector (4) has a lateral depression (30) into which one of the two side walls (29) is shape-lockingly inserted.

10. Plug-in unit according to claim 9, characterised in that the inserted side wall (29) has a plug (31) that engages in a blind bore (32) of the ejector (4).

11. Plig-in unit according to claim 10, characterised in that a nose (33) is arranged on the plug (31) and fits into a dimple (34) of the blind bore (32).

12. Plug-in unit according to claims 1 to 11, characterised in that at least one of the pivot pins (13, 13') has a detent area (37) on its mantle surface, and the associated bearing hole (25,) carries a corresponding counter-surface (38) and two laterally adjoining radial slits (39).

13. Plug-in unit according to claims 1 to 12, characterised in that insertion ramps (27) are provided at the bearing holes (25, 25').

14. Plug-in unit according to claims 1 to 13, characterised in that a pinhead (35) is provided laterally on the support bracket (2) opposite to which there is a depression (36) at the side wall (24, 28).

**Revendications**

1. Unité enfichable pour l'introduction dans des châssis équipés d'appareils électroniques, comprenant une plaquette à circuits imprimés portant des composants électroniques et électriques et équipée d'un connecteur sur laquelle est fixée à angle droit, au moyen d'un support, une plaque frontale, ainsi qu'un extracteur dont la partie poignée dépasse de la plaque frontale et qui, au moyen de trous de fixation dans deux parois latérales parallèles en saillie, est disposé de façon à pouvoir pivoter autour de deux pivots coaxiaux prévus dans la région de la plaque frontale, caractérisée en ce que la plaque frontale (3, 3′) présente sur ses bords longitudinaux (17) deux évidements (18) opposés dans lesquelles s'engagent les parois latérales (24, 28, 29) de l'extracteur (4), et que les deux pivots (13, 13′) dépassent dans ces évidements (18) et se situent dans le plan de la plaque frontale (3, 3′).

2. Unité enfichable selon la revendication 1, caractérisée en ce que les pivots (13, 13′) sont disposés sur le support (2).

3. Unité enfichable selon la revendication 2, caractérisée en ce que les pivots (13, 13′) sont disposés sur des blocs de support (12) dépassant du support (2) et s'engageant dans des évidements correspondants (19) de la plaque frontale (3).

4. Unité enfichable selon l'une des revendications 1 à 3, caractérisée en ce que le support (2) porte une face de butée (11) pour la plaquette à circuits imprimés (1).

5. Unité enfichable selon la revendication 1, caractérisée en ce que les pivots (13′) sont disposés sur la plaque frontale (3′).

6. Unité enfichable selon la revendication 5, caractérisée en ce que les pivots (13′) sont conformés sur la plaque frontale (3′).

7. Unité enfichable selon l'une des revendications 1 à 6, caractérisée en ce que les parois latérales (24) de l'extracteur (4) sont conformées en lames flexibles portant les trous de fixation (25, 25′).

8. Unité enfichable selon la revendication 7, caractérisée en ce que les lames flexibles sont conformées sur l'extracteur (4).

9. Unité enfichable selon l'une des revendications 1 à 6, caractérisée en ce que l'extracteur (4) comporte un évidement latéral (30) dans lequel l'une des deux parois latérales (29) est insérée à engagement positif.

10. Unité enfichable selon la revendication 9, caractérisée en ce que la paroi latérale (29) insérée comporte une broche (31) qui s'engage dans un trou borgne (32) de l'extracteur (4).

11. Unité enfichable selon la revendication 10, caractérisée en ce que sur la broche (31) est disposé un tenon (33) qui est adapté à un creux (34) du trou borgne (32).

12. Unité enfichable selon l'une des revendications 1 à 11, caractérisée en ce qu'au moins l'un des pivots (13, 13′) présente sur son enveloppe une surface d'arrêt (37), et que le trou de fixation associé (25, 25′) comporte une surface conjuguée (38) correspondante ainsi que deux fentes radiales (39) qui y font suite.

13. Unité enfichable selon l'une des revendications 1 à 12, caractérisée en ce que des chanfreins de guidage (27) sont prévus sur les trous de fixation (25, 25′).

14. Unité enfichable selon l'une des revendications 1 à 13, caractérisée en ce que sur le côté du support (2) est prévu un bossage (35) auquel fait face un creux (36) sur la paroi latérale (24, 28).

Fig. 1

26  24  4

26  16

22  20  23  21  25  24  42  41

3

17

15

19

18

43  40

2  7  8

14  12  13  35  11  9  10

1

5

6

EP 0 301 119 B1

Fig. 2

26  26

25  27

24

Fig. 3

31  30  32

29

33  34  22

36

28

Fig.4

Fig.5

Fig.6